Europäisches Patentamt

(19) European Patent Office

Office européen des brevets

(11) Numéro de publication : **0 127 499**
B1

(12) **FASCICULE DE BREVET EUROPÉEN**

(45) Date de publication du fascicule du brevet :
21.01.87

(51) Int. Cl.⁴ : **C 30 B 25/10**, C 30 B 23/06,
C 30 B 23/04, C 30 B 25/04

(21) Numéro de dépôt : **84400816.9**

(22) Date de dépôt : **20.04.84**

(54) Procédé de croissance amorphe d'un corps avec cristallisation sous rayonnement.

(30) Priorité : 25.04.83 FR 8306749

(43) Date de publication de la demande :
05.12.84 Bulletin 84/49

(45) Mention de la délivrance du brevet :
21.01.87 Bulletin 87/04

(84) Etats contractants désignés :
CH DE GB IT LI

(56) Documents cités :
JOURNAL OF CRYSTAL GROWTH, vol. 56, no. 2,
janvier 1982, North-Holland Publishing Company; H.T.
YANG et al.: "Pulsed laser evaporated Sn02 films",
pages 429-432.
APPLIED PHYSICS A. SOLIDS AND SURFACES, vol.
A30, no. 3, mars 1983, Springer-Verlag; D. Bäuerle et
al.: "Laser grown single crystals of silicon", pages
147-149.

(73) Titulaire : **COMMISSARIAT A L'ENERGIE ATOMIQUE**
**Etablissement de Caractère Scientifique Technique**
**et Industriel**
**31/33, rue de la Fédération**
**F-75015 Paris (FR)**

(72) Inventeur : **Chenevas-Paule, André**
**42, rue de Stalingrad**
**F-38100 Grenoble (FR)**
Inventeur : **Cuchet, Robert**
**Monestier du Percy**
**F-38930 Clelles (FR)**
Inventeur : **Eloy, Jean-François**
**505, Chemin du Menivol**
**F-38330 Saint Ismier (FR)**

(74) Mandataire : **Mongrédien, André et al**
**c/o BREVATOME 25, rue de Ponthieu**
**F-75008 Paris (FR)**

EP 0 127 499 B1

## Description

La présente invention concerne un procédé de croissance amorphe avec cristallisation locale sous rayonnement électromagnétique cohérent. Elle permet notamment l'obtention de couches minces semiconductrices cristallines.

On connaît plusieurs méthodes classiques de cristallisation. La méthode la plus simple à mettre en œuvre est le recuit thermique. Cette technique consiste à chauffer le film obtenu par croissance amorphe sur un substrat. Dans le cas du silicium, la température de chauffage est de l'ordre de 800 °C. Cette technique a l'avantage d'être simple, mais présente l'inconvénient de développer dans la couche des polycristaux maclés. D'autre part, cette technique est une technique globale, moins souple que les techniques de cristallisation ou de recristallisation locale.

On connaît aussi des techniques utilisant la photocristallisation telle que la technique de recristallisation par faisceau laser, balayé ou pulsé, qui réalise la recristallisation locale d'une couche par chauffage. L'inconvénient de cette technique est que la température atteinte au point d'impact du faisceau laser sur le film de croissance est souvent supérieure à la température de fusion du corps constituant ce film. Ceci induit des contraintes de dilatations différentielles entre la zone chauffée et alentour. Il en résulte de nombreux défauts dans le film tels que des criques et des défauts microscopiques responsables de courants de fuite. Mais selon ces techniques il s'agit encore d'un recuit, dans ce cas local, sur des couches de matériaux déjà déposées.

On connaît aussi une technique utilisant l'évaporation : la technique du jet moléculaire qui repose sur le principe de l'évaporation sous ultravide, c'est-à-dire sous une pression de $10^{-7}$ à $10^{-9}$ Pa à partir de cellules d'effusion de type Kundsen. On peut obtenir à partir de cette cellule, un jet de molécules ou d'atomes relativement directif pour recouvrir de façon épitaxiale une surface relativement petite.

Par cette technique, on obtient une épitaxie de couche très fine (quelques Angströms) et dont l'épaisseur est bien contrôlée. On peut ainsi en particulier élaborer des composés couche par couche. Par contre, l'inconvénient principal de cette technique est de nécessiter l'ultravide qui rend cette technologie difficile et coûteuse. Le coût d'obtention de couches par cette technique est donc en général incompatible avec la production de masse.

L'objectif de la présente invention est de pallier les inconvénients rencontrés dans les techniques décrites. L'objet de la présente invention est un procédé de croissance d'un corps sur un substrat qui autorise en même temps une croissance amorphe et une croissance cristalline.

De manière plus précise, l'invention a pour objet un procédé de croissance amorphe d'un corps avec cristallisation locale sous rayonnement électromagnétique cohérent, la croissance dudit corps étant réalisée sur un support contenu dans une enceinte sous vide, ladite enceinte contenant une source dudit corps, caractérisé en ce que :

on dépose de manière continue, sous forme amorphe, le corps sur le support et simultanément,

on irradie temporairement une ou plusieurs zones déterminées de la couche déposée sur le support pendant ledit dépôt continu, cette irradiation étant obtenue par un faisceau de rayonnement électromagnétique cohérent d'irradiation, la puissance W du faisceau et l'énergie du rayonnement électromagnétique cohérent d'irradiation étant aptes à réaliser une désorption desdites zones.

Selon un premier mode de réalisation de l'invention, le faisceau de rayonnement électromagnétique cohérent d'irradiation est émis sous forme d'impulsions à basse fréquence.

Selon un deuxième mode de réalisation de l'invention, le faisceau de rayonnement électromagnétique cohérent d'irradiation est une source lumineuse continue, balayée spatialement.

La photodésorption des zones irradiées « nettoie » ces zones, ce qui permet une croissance épitaxique sur celles-ci.

Il ne s'agit donc pas, dans le cas de l'invention, d'un recuit global ou local, mais d'une irradiation durant le dépôt du matériau qui provoque une cristallisation.

Selon une caractéristique secondaire très intéressante de l'invention, le corps à déposer est additionné d'éléments permettant son dopage. L'addition de ces éléments de dopage peut être séquentielle et être fonction du semiconducteur désiré.

Cette caractéristique permet ainsi d'obtenir très facilement soit des couches intrinsèques, soit des couches dopées p, soit des couches dopées n, ces différentes couches pouvant être réalisées successivement en changeant simplement l'atmosphère de l'enceinte.

Selon une caractéristique secondaire, la fréquence d'émission des impulsions d'irradiation est inférieure à 5 Hz.

Selon un mode de mise en œuvre préféré du procédé selon l'invention dans lequel ledit corps est du silicium, la longueur d'onde $\lambda$ du rayonnement électromagnétique cohérent d'irradiation est inférieure à 400 nm.

Selon un autre mode de mise en œuvre préféré du procédé selon l'invention dans lequel ledit corps est du silicium, la température du substrat est comprise entre 300 °C et 500 °C.

Selon un autre mode de mise en œuvre préféré de l'invention, ledit corps est du silicium et la source dudit corps est accompagnée de bore ou de phosphore.

Ce mode de réalisation permet d'obtenir des semiconducteurs à base de silicium comportant successivement des couches dopées p, n ou des couches intrinsèques, selon la présence ou l'absence d'éléments dopants.

Si la technique du jet moléculaire permet le dopage de type AsGa, elle n'est pas applicable au cas du silicium. En effet, de telles couches ne peuvent pas être obtenues actuellement par jet moléculaire silicium parce que le coefficient de collage du bore et du phosphore est trop faible à basse température (400 °C). La seule manière d'obtenir ce type de modulation spatiale de composition dans cette configuration (stable uniquement à basse température) est l'implantation ionique à basse énergie, ce qui complique la technique.

L'invention permet de remédier à cet état de fait parce qu'elle permet d'obtenir directement les couches n, p par incorporation de $B_2H_6$ ou $PH_3$ dans $SiH_4$, l'incorporation de P et B étant vraisemblablement assistée par la lumière.

Les caractéristiques et avantages de l'invention ressortiront mieux de la description qui va suivre, donnée à titre illustratif mais non limitatif, en référence aux figures annexées dans lesquelles :

la figure 1 représente de façon schématique un dispositif pour la mise en œuvre du procédé selon l'invention,

la figure 1a représente, de façon schématique, un autre dispositif de mise en œuvre du procédé,

la figure 2 représente l'énergie émise par le faisceau de rayonnement électromagnétique cohérent d'irradiation en fonction du temps,

la figure 3 représente de façon schématique une application réalisée au moyen du procédé selon l'invention.

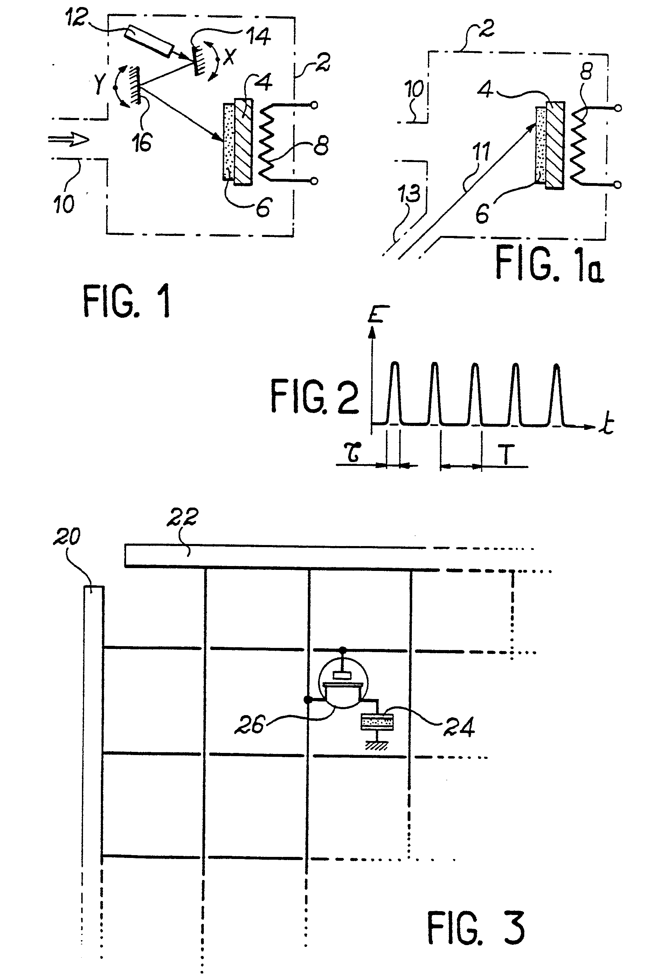

Le procédé selon l'invention consiste à faire croître un corps, tel que par exemple un semiconducteur, sous forme amorphe sur un substrat et simultanément à obtenir une cristallisation locale de ce corps par excitation au moyen d'un faisceau de rayonnement électromagnétique cohérent d'irradiation. On connaît de nombreuses méthodes de dépôt de semiconducteurs amorphes ou autres. On peut citer la pulvérisation cathodique, le jet moléculaire, le dépôt chimique en phase liquide, le dépôt chimique en phase vapeur assisté ou non par plasma ou autres. A titre d'exemple, on a représenté sur la figure 1 un dispositif pour la mise en œuvre de la méthode de dépôt chimique en phase vapeur.

Ce dispositif comprend une enceinte 2 sous vide contenant un support 4 sur lequel croît le corps à déposer, constituant ainsi une couche 6. Le support 4 peut être chauffé à l'aide d'un moyen 8. Le corps à déposer est évaporé et introduit dans l'enceinte par un orifice 10. Le dispositif comprend également une source de rayonnement électromagnétique cohérent d'irradiation 12 émettant un faisceau, par exemple un faisceau laser qui, après deux réflexions sur des miroirs 14 et 16, atteint la couche 6. Le miroir 14 réalise une déviation du faisceau laser dans une direction parallèle à un des bords du support 4 et le miroir 16 effectue une déviation de ce même faisceau selon une direction orthogonale à celle du miroir 14. L'action combinée des deux miroirs 14 et 16 permet donc d'atteindre avec le faisceau de rayonnement d'irradiation n'importe quel point de la surface de la couche 6. Elle permet aussi de réaliser un balayage d'une partie de ladite surface ou de sa totalité.

Dans le cas d'un dépôt de silicium, on obtient une couche 6 amorphe si la température de l'enceinte est inférieure à 600 °C. Il faut par ailleurs que cette température soit suffisamment élevée pour que le silicium se condense sur la couche 6. On choisit par exemple une température de l'ordre de 400 °C.

Le moyen 12 qui peut être par exemple un faisceau laser, émet un rayonnement électromagnétique cohérent d'irradiation qui réalise une cristallisation locale du silicium déposé sur la couche 6. Ce faisceau peut être dirigé sur un point de la surface de la couche 6, mais il peut également balayer toute la surface grâce aux deux miroirs 14 et 16. Ce rayonnement électromagnétique cohérent est émis sous forme d'impulsions très courtes, par exemple de l'ordre d'une durée de 10 ns, à une fréquence de l'ordre de quelques hertz. Au lieu d'utiliser un rayonnement électromagnétique cohérent émis sous forme d'impulsions très courtes, on pourrait utiliser un rayonnement électromagnétique cohérent continu balayé spatialement. Ce rayonnement électromagnétique cohérent d'irradiation est constitué de rayons intenses aptes à désorber la zone de la couche 6 excitée. Par exemple dans le cas d'une couche 6 en silicium, le rayonnement d'irradiation peut être un rayonnement ultraviolet. Cette irradiation, pulsée ou continue, n'effectue pas un recuit de couches déjà déposées, mais à chaque impact, l'énergie des photons ultraviolets et la puissance du faisceau désorbent la surface, c'est-à-dire apporte de l'énergie aux atomes de silicium adsorbés, mais non encore liés chimiquement, ce qui leur permet de se déplacer et ce qui favorise donc la croissance cristalline. Les impulsions du rayonnement ultraviolet nettoient donc la surface et la rendent apte à l'épitaxie.

Ce procédé permet donc une croissance épitaxiale d'une couche de silicium à basse température (400 °C) et sur de grandes surfaces (en balayant le faisceau de rayonnements ultraviolets). Ce procédé peut être notamment utilisé pour obtenir des polycristaux sur $SiO_2$ fondu ou d'autres substrats isolants, des monocristaux ou des couches épitaxiques sur du silicium cristallin, du saphir, du grenat, des fluorures (tels que $CaF_2$) ou autres. Il peut aussi être utilisé en graphoépitaxie.

On reconnaît sur la figure 1a l'enceinte 2 renfermant un support 4 sur lequel croît une couche 6 ; ce support 4 pouvant être chauffé par un moyen 8. Le composé contenant le matériau à déposer pénètre dans l'enceinte 2 par le conduit 10. Mais, dans le dispositif représenté ici, le rayonnement électromagnétique cohérent 11 introduit par 13 dans l'enceinte 2 frappe directement la couche 6 en cours de formation. Des moyens, non représentés, permettent le déplacement éventuel soit du rayonnement électromagnétique cohérent, soit du support 4 et de la couche 6, afin d'effectuer un balayage.

Sur la figure 2, on a représenté un diagramme portant l'énergie du faisceau du rayonnement ultraviolet en fonction du temps. La largeur τ de chaque impulsion est de l'ordre de 15 ns. La fréquence des impulsions est au plus de quelques hertz ; elle peut être par exemple de 0,5 Hz, c'est-à-dire une période T de deux secondes. Le faisceau laser est constitué d'un rayonnement ultraviolet intense, la longueur d'onde λ de ce rayonnement étant par exemple de 350 nm et la puissance W du laser de 35 MW.

Par le procédé de l'invention, on obtient donc une couche de silicium dans laquelle coexistent des régions amorphes et des régions cristallines. Une telle structure a beaucoup d'applications industrielles parmi lesquelles on peut citer la réalisation de circuits de microélectronique sur substrats isolants ou la réalisation de circuits tridimensionnels, la réalisation de registres à décalage pour écran plat à cristaux liquides, la réalisation des circuits électroniques d'adressage des barrettes de photodétection ou l'électronique de décodage de mémoires à bulles. En opérant dans des conditions identiques à celles données en référence à la figure 2, on a pu obtenir une séquence : p (10 nm (100 Å)) ; i (50 nm (500 Å)) ; n (10 nm (100 Å)) ; cette séquence étant répétée périodiquement pour obtenir une structure nipi... (très photosensible, avec possibilité de modulation du taux d'absorption α et du spectre de luminescence).

On a représenté sur la figure 3 un circuit d'adressage pour écran à cristaux liquides. Le circuit d'adressage comprend un registre d'adressage en ligne 20 et un registre d'adressage en colonne 22. L'adressage de chaque élément 24 de l'écran à cristaux liquides est réalisé par la fermeture d'un interrupteur, tel qu'un transistor 26, commandé par une ligne du registre 20 et par un signal de commande émis par une colonne du registre 22.

L'adressage s'effectuant classiquement ligne par ligne, le registre 22 travaille à une fréquence p fois plus élevée que le registre 20, si l'écran à cristaux liquides a p colonnes. Ainsi, le registre 22 doit être réalisé obligatoirement en silicium cristallin pour pouvoir travailler à haute fréquence alors que le registre 20 peut être réalisé aussi bien en silicium amorphe qu'en silicium cristallin. Ce circuit d'adressage peut donc être réalisé avantageusement avec le procédé selon l'invention, le registre 20 étant en silicium amorphe et le registre 22 en silicium cristallisé par un rayonnement d'irradiation.

## Revendications

1. Procédé de croissance amorphe d'un corps avec cristallisation locale sous rayonnement électromagnétique cohérent, la croissance dudit corps étant réalisée sur un support contenu dans une enceinte sous vide, ladite enceinte contenant une source dudit corps, caractérisé en ce que :

on dépose de manière continue, sous forme amorphe, le corps sur le support et simultanément,

on irradie temporairement une ou plusieurs surfaces déterminées de la couche déposée sur le support pendant ledit dépôt continu, cette irradiation étant obtenue par un faisceau de rayonnement électromagnétique cohérent d'irradiation, la puissance W du faisceau et la longueur d'onde λ du rayonnement électromagnétique cohérent d'irradiation étant aptes à réaliser une désorption desdites surfaces.

2. Procédé selon la revendication 1, caractérisé en ce que le faisceau de rayonnement électromagnétique cohérent d'irradiation est émis sous forme d'impulsions à basse fréquence.

3. Procédé selon la revendication 1, caractérisé en ce que le faisceau de rayonnement électromagnétique cohérent d'irradiation est une source lumineuse continue balayée spatialement.

4. Procédé selon l'une quelconque des revendications 1 à 3, caractérisé en ce que la source dudit corps est additionnée de façon séquentielle d'éléments dopants.

5. Procédé selon les revendications 1 et 2, caractérisé en ce que la fréquence d'émission des impulsions d'irradiation est inférieure à 5 Hz.

6. Procédé selon l'une quelconque des revendications 1 à 5, dans lequel ledit corps est du silicium, caractérisé en ce que la longueur d'onde λ du faisceau de rayonnement électromagnétique cohérent d'irradiation est inférieure à 400 nm.

7. Procédé selon la revendication 6, dans lequel ledit corps est du silicium, caractérisé en ce que la température du substrat est comprise entre 300 °C et 500 °C.

8. Procédé selon l'une quelconque des revendications 5 à 7, caractérisé en ce que ledit corps est du silicium dopé par du bore.

9. Procédé selon l'une des revendications 5 à 7, caractérisé en ce que ledit corps est du silicium dopé par du phosphore.

## Claims

1. Process for the amorphous growth of a substance with local crystallization under coherent electromagnetic radiation, the growth of the said substance being carried out on a support contained in an enclosure under vacuum, the said enclosure containing a source of the said substance, characterized in that :

the substance is deposited in a continuous manner, in amorphous form, on the support, and simultaneously

one or more specified surfaces of the layer deposited on the support is irradiated temporarily during the said continuous depositing, this irradiation being obtained by a beam of irradiating coherent electromagnetic radiation, the power W of the beam and the wavelength λ of the irradiating

coherent electromagnetic radiation being suitable to effect a desorption from the said surfaces.

2. Process according to Claim 1, characterized in that the beam of irradiating coherent electromagnetic radiation is emitted in the form of low-frequency pulses.

3. Process according to Claim 1, characterized in that the beam of irradiating coherent electromagnetic radiation is a spatially scanned continuous luminous source.

4. Process according to any one of Claims 1 to 3, characterized in that dopant elements are added in a sequential manner to the source of the said substance.

5. Process according to Claims 1 and 2, characterized in that the frequency of emission of the pulses of irradiation is below 5 Hz.

6. Process according to any one of Claims 1 to 5, wherein the said substance is silicon, characterized in that the wavelength λ of the beam of irradiating coherent electromagnetic radiation is below 400 nm.

7. Process according to Claim 6, wherein the said substance is silicon, characterized in that the temperature of the substrate is within the range between 300 °C and 500 °C.

8. Process according to any one of Claims 5 to 7, characterized in that the said substance is silicon doped with boron.

9. Process according to one of Claims 5 to 7, characterized in that the said substance is silicon doped with phosphorus.

**Patentansprüche**

1. Verfahren zum amorphen Wachsen eines Gegenstandes mit lokaler Kristallisation bei elektromagnetischer, kohärenter Strahlung, wobei das Wachsen des Gegenstandes auf einem Träger durchgeführt wird, der in einer Vakuumkammer enthalten ist, die eine Quelle des Gegenstandes enthält, dadurch gekennzeichnet, daß man

fortlaufend in amorpher Form den Gegenstand auf dem Träger aufbringt und gleichzeitig

vorübergehend eine oder mehrere bestimmte Oberflächen der auf dem Träger während des fortlaufenden Aufbringens niedergeschlagenen Schicht bestrahlt, wobei diese Bestrahlung mit einem Strahlenbündel elektromagnetischer, kohärenter Strahlung erhalten wird und die Leistung (W) des Bündes und die Wellenlänge λ der elektromagnetischen, kohärenten Strahlung eine Desorption der Oberflächen durchführen kann.

2. Verfahren nach Anspruch 1, dadurch gekennzeichnet, daß das Bündel elektromagnetischer, kohärenter Strahlung zur Bestrahlung in Impulsform mit Niederfrequenz ausgesandt wird.

3. Verfahren nach Anspruch 1, dadurch gekennzeichnet, daß das Bündel elektromagnetischer, kohärenter Strahlung zur Bestrahlung eine räumlich abgelenkte, andauernde Lichtquelle ist.

4. Verfahren nach einem der Ansprüche 1 bis 3, dadurch gekennzeichnet, daß der Quelle des Gegenstandes aufeinanderfolgend Dotierungselemente zugeführt werden.

5. Verfahren nach Anspruch 1 und 2, dadurch gekennzeichnet, daß die Aussendefrequenz der Bestrahlungsimpulse kleiner als 5 Hz ist.

6. Verfahren nach einem der Ansprüche 1 bis 5, bei dem der Gegenstand aus Silicium ist, dadurch gekennzeichnet, daß die Wellenlänge des Bündels der elektromagnetischen, kohärenten Strahlung zur Bestrahlung kleiner als 400 nm ist.

7. Verfahren nach Anspruch 6, bei dem der Gegenstand aus Silicium ist, dadurch gekennzeichnet, daß die Temperatur des Trägers zwischen 300 °C und 500 °C liegt.

8. Verfahren nach einem der Ansprüche 5 bis 7, dadurch gekennzeichnet, daß der Gegenstand aus mit Bor dotiertem Silicium ist.

9. Verfahren nach einem der Ansprüche 5 bis 7, dadurch gekennzeichnet, daß der Gegenstand aus mit Phosphor dotiertem Silicium ist.

FIG. 1

FIG. 1a

FIG. 2

FIG. 3